# EUROPÄISCHE PATENTSCHRIFT

(11) **EP 4 193 814 B1**
(45) Veröffentlichungstag und Bekanntmachung des Hinweises auf die Patenterteilung: **05.06.2024**
(21) Anmeldenummer: 21791371.4
(22) Anmeldetag: 14.10.2021
(51) Int. Cl.: H05K 1/02, C04B 37/02, H05K 1/14, H05K 1/03, H05K 3/46

(54) **LEITERPLATTE, METALL-KERAMIK-SUBSTRAT ALS EINSATZ UND VERFAHREN ZUR HERSTELLUNG EINES SOLCHEN EINSATZES**
PRINTED CIRCUIT BOARD, METAL-CERAMIC SUBSTRATE AS AN INSERT AND METHOD FOR PRODUCING SUCH AN INSERT
CARTE DE CIRCUIT IMPRIMÉ, SUBSTRAT EN MÉTAL-CÉRAMIQUE EN TANT QU'INSERT ET PROCÉDÉ DE FABRICATION D'UN TEL INSERT

(30) Priorität: 15.10.2020 DE 102020127167
(43) Veröffentlichungstag der Anmeldung: 14.06.2023
(73) Patentinhaber: Rogers Germany GmbH, 92676 Eschenbach (DE)
(72) Erfinder: MEYER, Andreas, 95469 Speichersdorf (DE); GIL, Vitalij, 91217 Hersbruck (DE)
(74) Vertreter: Müller Schupfner & Partner Patent- und Rechtsanwaltspartnerschaft mbB (Muc)
(86) Internationale Anmeldenummer: PCT/EP2021/078457
(87) Internationale Veröffentlichungsnummer: WO 2022/079174

(56) Entgegenhaltungen:
- EP-A1- 2 566 310
- EP-A1- 2 717 310
- DE-A1-102004 019 431
- DE-A1-102018 104 521
- US-A1- 2012 329 183

## Beschreibung

Die vorliegende Erfindung betrifft eine Leiterplatte, ein Metall-Keramik-Substrat als Einsatz für eine solche Leiterplatte und ein Verfahren zur Herstellung eines solchen Einsatzes.

Leiterplatten sind hinlänglich aus dem Stand der Technik bekannt. Solche Leiterplatten dienen als Träger für elektrische Schaltkreise, die aus Leiterbahnen, elektrischen Komponenten und/oder Anschlüssen gebildet bzw. zusammengesetzt sind. Hierbei sind die elektrischen Schaltkreise vorzugsweise an einer Bauteilseite der Leiterplatte ausgebildet. Üblicherweise bestehen solche Leiterplatten auch PCB (printed circuit board genannt) aus einem Kunststoff, insbesondere einem faserverstärkten Kunststoff, einem Epoxidharz und/oder einem Hartpapier. Die Verwendung solcher Materialien erweist sich insbesondere als kostengünstig und einfach in der Handhabung während des Fertigungsprozesses. Allerdings hat es sich herausgestellt, dass die genannten Materialien für Leiterplatten eine begrenzte Wärmeleitfähigkeit aufweisen, die allerdings erforderlich ist, um Wärme abzutransportieren, die im Betrieb von elektrischen Bauteilen ausgeht. Auch diese Isolationsfähigkeit ist eingeschränkt. Mit dem zunehmenden Leistungsvermögen von elektronischen Bauteilen sind die aus den üblichen Materialien gefertigten Leiterplatten daher ungeeignet, dauerhaft den im Betrieb entstehenden Belastungen standzuhalten und gute Isolationseigenschaften bereitzustellen.

Auf der anderen Seite zeichnen sich Leiterplatten, die als Metall-Keramik-Substrate ausgebildet sind, durch eine hohe Isolationsfähigkeit aus und sie weisen typischerweise höhere Wärmeleitfähigkeiten im Vergleich zu denjenigen der oben genannten Materialien auf. Allerdings ist die Herstellung von Metall-Keramik-Substraten aufwendiger und kostenintensiver als die Herstellung von Leiterplatten aus Kunststoff, Epoxidharz und/oder Hartpapier.

EP 2 566 310 A1 offenbart den Oberbegriff des unabhängigen Anspruchs. Ausgehend vom Stand der Technik macht es sich die vorliegende Erfindung zur Aufgabe, Leiterplatten bereitzustellen, die den gehobenen Ansprüchen zum Wärmeabtransport und zur Isolationsfähigkeit von elektronischen Bauteilen genügen und gleichzeitig mit einem geringeren Kostenaufwand produziert werden können.

Diese Aufgabe wird gelöst durch die Leiterplatte gemäß Anspruch 1, und ein Verfahren gemäß Anspruch 12 Weitere Ausführungsbeispiele sind den Unteransprüchen und der Beschreibung zu entnehmen.

Gemäß einem ersten Aspekt der vorliegenden Erfindung ist eine Leiterplatte für elektrische bzw. elektronische Bauteile und/oder Leiterbahnen vorgesehen, umfassend
- einen Grundkörper, der sich entlang einer Haupterstreckungsebene erstreckt, und
- einen Einsatz, der in den Grundkörper integriert bzw. eingelassen ist,
wobei der Einsatz ein Metall-Keramik-Substrat ist und formschlüssig und vorzugsweise stoffschlüssig mit dem Grundkörper in einer senkrecht zur Haupterstreckungsebene verlaufenden Richtung zusammenwirkt.

Gegenüber den aus dem Stand der Technik bekannten Leiterplatten ist es erfindungsgemäß vorgesehen, dass der Grundkörper der Leiterplatte nicht vollständig aus einem der gängigen Materialien, wie beispielsweise Kunststoff, Hartpapier und/oder Epoxidharz, gebildet ist, sondern ein Abschnitt der Leiterplatte zumindest aus einem Metall-Keramik-Substrats geformt ist. Insbesondere ist das Metall-Keramik-Substrat eingebettet bzw. eingesetzt in den Grundkörper der Leiterplatte, um gezielt lokal für eine erhöhte Wärmeleitfähigkeit zu sorgen. Dadurch ist es beispielsweise möglich, in der Leiterplatte Metall-Keramik-Substrate als Einsätze in solchen Bereichen einzufügen bzw. einzubetten, in denen mit einer erhöhten Wärmeentwicklung zu rechnen ist. Beispielsweise ist der Einsatz in einer senkrecht zur Haupterstreckungsebene verlaufenden Richtung unterhalb des elektrischen oder elektronischen Bauteils angeordnet, das im Betrieb verantwortlich ist für eine erhöhte Wärmeentwicklung. Gleichzeitig ist es möglich, den Großteil des Grundkörpers aus einem Material, wie beispielsweise einem Kunststoff, insbesondere einem faserverstärkten Kunststoff, Epoxidharz oder einem Hartpapier, zu fertigen, das kostengünstig und einfach zu verarbeiten ist. Falls gewünscht, kann dadurch auch zusätzlich ein Kraftschluss zwischen Einsatz und Grundkörper erzielt werden.

Vorzugsweise ist es vorgesehen, dass der Grundkörper aus einem anderen Material gefertigt ist als der Einsatz. Insbesondere ist es vorgesehen, dass der Grundkörper im Wesentlichen frei von Keramik ist oder kein Keramikelement als Isolationsschicht oder Stabilisierungsschicht vorsieht. Vorzugsweise enthält der Grundkörper weniger als 10 Gew.-%, bevorzugt weniger als 5 Gew.-% und besonders bevorzugt weniger als 3 Gew.-% Keramik.

Dabei ist es insbesondere vorgesehen, dass ein Anteil des Metall-Keramik-Substrats am Anteil der Leiterplatte kleiner als 30%, vorzugsweise kleiner als 20% und besonders bevorzugt kleiner als 10% ist. Weiterhin ist es vorgesehen, dass der Einsatz von der Bauteilseite der Grundplatte bis zur Rückseite des Grundkörpers der Leiterplatte reicht. Mit anderen Worten: der Einsatz schließt bündig mit dem Grundkörper in einer senkrecht zur Haupterstreckungsebene verlaufenden Richtung zu beiden Seiten, d. h. zur Bauteilseite und zur Rückseite, im Wesentlichen bündig ab. Durch den Formschluss zwischen dem Grundkörper und dem als Einsatz dienenden Metall-Keramik-Substrat wird insbesondere eine dauerhafte Bindung zwischen dem Metall-Keramik-Substrat und dem Grundkörper realisiert, die verhindert, dass sich der Einsatz aus der Leiterplatte löst. Vorzugsweise wirkt der Formschluss in beide möglichen Richtungen, die senkrecht zur Haupterstreckungsebene des Grundkörpers verlaufen. Weiterhin ist es vorstellbar, dass neben dem Einsatz weiterer Einsätze im Grundkörper angeordnet sind. Zudem ist es denkbar, dass der Einsatz nur an der Bauteilseite bündig mit dem Grundkörper abschließt und die Rückseite des Metall-Keramik-Substrats ist umschlossen vom Grundkörper. Mit anderen Worten: Das Metall-Keramik-Substrat bzw. der Einsatz ist in eine Vertiefung im Grundkörper der Leiterplatte eingelassen bzw. eingesetzt. Dadurch ergibt sich auch ein Formschluss parallel zur Haupterstreckungsebene.

Insbesondere ist es vorgesehen, dass das Metall-Keramik-Substrat und der Grundkörper derart gestaltet sind, dass ihre thermischen Ausdehnungskoeffizienten möglichst ähnlich sind. Mit anderen Worten: Eine Differenz des thermischen Ausdehnungskoeffizienten des Einsatzes und des Grundkörpers wird möglichst klein gehalten. Hierzu wird beispielsweise eine entsprechende Dicke des Keramikelements im Metall-Keramik-Substrat eingestellt. Vorstellbar ist auch, dass zur Anpassung des thermomechanischen Ausdehnungskoeffizienten eine Stabilisierungsschicht vorgesehen ist oder mehrere Metallschichten und/oder verschiedene Metallisierungen (z. B. sind Bauteilmetallisierungen und Rückmetallisierungen aus verschiedenen Metallen bzw. Materialien gefertigt) verwendet werden, um in entsprechender Weise für die gewünschte Anpassung zu sorgen. Dadurch kann sichergestellt werden, dass durch im Betrieb entstehende Ausdehnungen keine signifikanten mechanischen Spannungen zwischen der Grundplatte und dem Metall-Keramik-Substrat entstehen, die beispielsweise zur Rissbildung führen könnten. Vorzugsweise ist es auch vorstellbar, dass verschiedene Keramiklagen in einem Metall-Keramik-Substrate mit mehreren Keramiklagen verwendet werden.

Es hat sich als vorteilhaft erwiesen, wenn zusätzlich zu dem Formschluss ein Stoffschluss zwischen der Seitenfläche des Einsatzes und dem Grundkörper realisiert wird.

Gemäß einer bevorzugten Ausführungsform ist es vorgesehen, dass zum Ausbilden des formschlüssigen Zusammenwirkens
- das Metall-Keramik-Substrat an einer nicht parallel zur Haupterstreckungsebene verlaufenden Seitenfläche profiliert ist und/oder
- ein Keramikelement des Metall-Keramik-Substrats in einer parallel zur Haupterstreckungsebene verlaufenden Richtung gegenüber einer Bauteilmetallisierung und/oder der Rückseitenmetallisierung des Metall-Keramik-Substrats um eine erste Länge vorsteht.

Beispielsweise ist es vorgesehen, dass eine Seitenfläche, insbesondere eine Seitenfläche der Bauteilmetallisierung und/oder Rückseitenmetallisierung konkav und/oder konvex gewölbt ist. Alternativ ist es auch vorstellbar, dass die Bauteilmetallisierung gestuft ausgebildet ist. Insbesondere ist es vorgesehen, dass der Grundkörper in die rückstehenden bzw. vorstehenden Verläufe an den Seitenflächen der Metallisierung und/oder Rückmetallisierung eingreifen, um so den Formschluss in eine Richtung bzw. beide Richtungen zu veranlassen, die senkrecht zur Haupterstreckungsebene verläuft bzw. verlaufen. Beispielsweise ist es vorstellbar, dass der äußerste Rand der Bauteilmetallisierung gestuft ist, insbesondere derart gestuft, dass der offene Bereich der Stufe auf der der Bauteilseite und/oder der Rückseite zugewandten Seite ausgebildet ist. In entsprechender Weise kann ein Bauteil derart auf der Bauteilmetallisierung angeordnet werden, dass unter Berücksichtigung eines isotropen Transports der Wärme die Wärmespreizung von der Bauteilmetallisierung vollständig erfasst wird. Die ohnehin hier nicht zum Wärmetransport beitragenden Abschnitte der Bauteilmetallisierung werden in diesem gestuften Verlauf in entsprechender Weise entnommen und durch den Grundkörper ersetzt. Vorzugsweise wird ein vorstehender Abschnitt des Keramikelements zur Ausbildung des Formschlusses verwendet. Insbesondere handelt es sich um den Abschnitt, der als sogenannter Pullback bekannt ist und für die ausreichende Isolation zwischen Bauteilmetallisierung und Rückseitenmetallisierung sorgt.

Vorzugsweise ist es vorgesehen, dass die erste Länge einen Wert zwischen 20 µm und 100 µm und besonders bevorzugt zwischen 25 µm und 60 µm annimmt. Es hat sich herausgestellt, dass durch eine entsprechende Dimensionierung bereits ein wirkungsvoller Formschluss realisiert werden kann und durch die zusätzliche isolierende Wirkung des Materials, aus dem der Grundkörper der Leiterplatte geformt ist, gleichzeitig auch die elektrische Isolation zwischen Bauteilmetallisierung und Rückseitenmetallisierung gewährleistet wird. Durch diesen vergleichsweise sehr kleinen vorstehenden Abschnitt des Keramikelements, d. h. diesen vergleichsweise kleinen sogenannten Pullback, ist eine möglichst platzsparende Integration des Einsatzes, d. h. des Metall-Keramik-Substrats, im Grundkörper der Leiterplatte möglich. Vorzugsweise ist es vorgesehen, dass das Metall-Keramik-Substrat in einer parallel zur Haupterstreckungsebene bemessenen Ebene eine maximale Ausdehnung aufweist, die einen Wert zwischen 1 mm und 200 mm, bevorzugt zwischen 4 mm und 60 mm und besonders bevorzugt zwischen 6 mm und 30 mm annimmt. Dadurch werden vergleichsweise kleindimensionierte Einsätze bereitgestellt, die bedarfsabhängig für eine lokale Erhöhung der Wärmeleitfähigkeit in der Leiterplatte herangezogen werden können. Insbesondere können vergleichsweise viele einzelne Einsätze aus einer Großkarte bereitgestellt werden. Eine solche Großkarte wird festgelegt durch das Format unmittelbar nach der Anbindung der Bauteilmetallisierung an die Rückseitenmetallisierung, was über ein entsprechendes Anbindungsverfahren erfolgt. Es ist auch vorstellbar, dass die erste Länge einen negativen Wert annimmt. Dann steht die Bauteilmetallisierung und/oder die Rückseitenmetallisierung gegenüber dem Keramikelement in einer Richtung parallel zur Haupterstreckungsebene vor. Dabei kann die erste Länge die oben genannten absoluten Werte annehmen. Insbesondere ist es vorgesehen, dass die Seitenfläche derart profiliert ist, dass sich eine Modulationstiefe bzw. -höhe einstellt, die einen Wert zwischen 20 µm und 100 µm und besonders bevorzugt zwischen 25 µm und 60 µm annimmt. Dabei ist als Modulationstiefe bzw. - höhe eine in einer parallel zur Haupterstreckungsebene verlaufenden Richtung bemessene Abweichung von einem gedachten, zylindrischen Außenverlauf zu verstehen, der einer schmalsten Stelle des Metall-Keramik-Substrats zugeordnet ist (gemessen in Ebenen parallel zur Haupterstreckungsebene). Der gedachte zylindrische Außenverlauf erstreckt sich dabei senkrecht zur Haupterstreckungsebene. Sofern die Modulationstiefe durch ein gegenüber der Bauteilmetallisierung und/oder Rückseitenmetallisierung vorstehendes Keramikelement gebildet wird, kann die Modulationstiefe der ersten Länge entsprechen. Es ist auch vorstellbar, dass die Modulationstiefe dadurch verursacht wird, dass die Bauteilmetallisierung und/oder das Keramikelement gegenüber der Rückseitenmetallisierung in einer parallel zur Haupterstreckungsebene verlaufenden Richtung vorsteht. Beispielsweise ist es auch vorstellbar, dass das die Seitenfläche im Bereich des Keramikelememts einen gegenüber der Stapelrichtung schrägen Verlauf aufweist (mit anderen Worten: Die Oberseite und die Unterseite des Keramikelements haben unterschiedlich große Durchmesser).

Beispielsweise ist es vorstellbar, dass sich der Verlauf der Seitenfläche bzw. Seitenflächen im Bereich der Bauteilmetallisierung und/oder Rückseitenmetallisierung parallel zur Stapelrichtung erstreckt (d. h. der Querschnitt der Bauteilmetallisierung und/oder der Rückseitenmetallisierung ist in Stapelrichtung gesehen im Wesentlichen im Bereich der Bauteilmetallisierung bzw. der Rückseitenmetallisierung konstant.). Die Modulationstiefe wird dann vorzugsweise durch einen Absatz auf Höhe des Keramikelements realisiert. Dabei kann die Modulationstiefe durch eine Profilierung oder eine Modulierung im Bereich des Keramikelements erzeugt werden, wobei die Profilierung in Stapelrichtung kontinuierlich über die Dicke des Keramikelements oder diskret bzw. sprunghaft auf Höhe des Keramikelements erfolgen kann.

Weiterhin ist es vorstellbar, dass der Einsatz einen oder mehrere Vorsprünge aufweist, die in einer parallel zur Haupterstreckungsebene verlaufenden Richtung gegenüber dem generellen Verlauf des äußeren Umfangs des Einsatzes vorsteht bzw. vorstehen. Dieser, vorzugsweise nasenförmige, Vorsprung kann in vorteilhafter Weise einen zusätzlichen Formschluss in Umlaufrichtung entlang des Außenumfangs bedingen, der eine drehfeste Anordnung im Grundkörper unterstützt. Es hat sich dabei in vorteilhafter Weise herausgestellt, dass ein solcher Vorsprung durch Heraustrennen der Metall-Keramik-Substrate aus einer Großkarte mittels Laserlicht und/oder Wasserschneiden entsteht.

Wesentliche Bestandteile der Metall-Keramik-Substrate sind eine Isolationsschicht, die bevorzugt vollständig aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden. Vorzugsweise ist es vorgesehen, dass beim als Einsatz vorgesehenen Metall-Keramik-Substrat die Bauteilmetallisierung nicht strukturiert ist, sondern eine geschlossene Fläche ausbildet. Voraussetzung für das Bereitstellen eines solchen Metall-Keramik-Substrats ist eine dauerhafte Anbindung der Metallschicht an die Keramikschicht. Neben einem sogenannten Direktmetallanbindungsverfahren, d. h. einem DCB- oder DAB-Verfahren, ist auch die Anbindung über ein Aktivlotverfahren, ein Dickfilmschichtverfahren, Diffusionsbonden und/oder heißisostatisches Anbinden denkbar.

Als Materialien für die Metallschicht bzw. Metallisierungen sind Kupfer, Aluminium, Molybdän, Wolfram und/oder deren Legierungen wie z. B. CuZr, AlSi oder AlMgSi, sowie Laminate wie CuW, CuMo, CuAl und/oder AlCu oder MMC (metal matrix composite), wie CuW, CuMo oder AlSiC, vorstellbar. Weiterhin ist bevorzugt vorgesehen, dass die Metallschicht bzw. Metallisierung am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG (*"electroless nickel immersion gold"*) oder ein Kantenverguss an der Metallisierung zur Unterdrückung einer Rissbildung bzw. -weitung denkbar. Beispielsweise unterscheidet sich auch das Metall der Bauteilmetallisierung von dem Metall der Rückseitenmetallisierung.

Vorzugsweise weist das Keramikelement Al₂O₃, Si₃N₄, AlN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Keramikelement zusammengefügt sind.

Vorzugsweise ist es vorgesehen, dass das Metall-Keramik-Substrat in der Haupterstreckungsebene ein rundes Profil oder eine abgerundete Ecke aufweist. Eine entsprechende Ausgestaltung des Querschnitts des Einsatzes in einer Ebene, die parallel zur Haupterstreckungsebene verläuft erweist sich insbesondere deswegen als vorteilhaft, weil dadurch eine Kerbwirkung auf dem Grundkörper der Leiterplatte reduziert werden kann. Dadurch kann wiederrum die Lebensdauer der Leiterplatte mit Einsatz verlängert werden.

Vorzugsweise ist es vorgesehen, dass das Metall-Keramik-Substrat ein Keramikelement aufweist, wobei an dem Keramikelement eine Bauteilmetallisierung angebunden ist, wobei
- eine der Bauteilmetallisierungen in einer senkrecht zur Haupterstreckungsebene verlaufenden Stapelrichtung gegenüberliegende Rückseitenmetallisierung vorgesehen bzw. ausgebildet ist, und/oder
- eine Stabilisierungsschicht, beispielsweise in Form eines weiteren Keramikelements, vorgesehen bzw. ausgebildet ist, wobei zwischen dem Keramikelement und der Stabilisierungsschicht eine metallische Zwischenschicht angeordnet ist, und/oder
- die Bauteilmetallisierung und/oder die Rückseitenmetallisierung eine erste Metallschicht und/oder eine zweite Metallschicht umfasst, wobei die erste Metallschicht und die zweite Metallschicht übereinander angeordnet sind.

Insbesondere ist es möglich, durch die entsprechende Ausgestaltung des Metall-Keramik-Substrats Einfluss zu nehmen auf den thermischen Ausdehnungskoeffizienten des Einsatzes, um diesen anzupassen an den thermischen Ausdehnungskoeffizienten des Grundkörpers. Beispielsweise ist es vorstellbar, die Stabilisierungsschicht aus einem anderen Material zu gestalten oder entsprechend zu dimensionieren. Auch die Dicke des Keramikelements kann dazu genutzt werden, den thermomechanischen Ausdehnungskoeffizienten des Einsatzes dahingehend zu optimieren, dass mechanische Spannungen zwischen dem Grundkörper und dem Einsatz reduziert werden. Vorzugsweise unterscheidet sich die erste Metallschicht von einer zweiten Metallschicht in Hinblick auf eine Körnung, wobei vorzugsweise eine Körnung in der ersten Metallschicht kleiner ist als eine Körnung in der zweiten Metallschicht und/oder besonders bevorzugt eine Dicke der ersten Metallschicht dünner ist als eine zweite Metallschicht. Weiterhin ist es vorstellbar, dass eine Dicke der Bauteilmetallisierung sich unterscheidet von einer Dicke der Rückseitenmetallisierung. Dadurch ist es in vorteilhafter Weise möglich, eine Höhenlage des Keramikelements innerhalb des Grundkörpers der Leiterplatte zu beeinflussen und insbesondere dafür zu sorgen, dass das isolierend wirkende Keramikelement zur Rückseite hin und von der Bauteilseite weg versetzt in dem Grundkörper angeordnet ist oder andersrum.

Ein weiterer Gegenstand der vorliegenden Erfindung ist ein Metall-Keramik-Substrat als Einsatz für eine Leiterplatte gemäß der vorliegenden Erfindung. Alle für die Leiterplatte beschriebenen Eigenschaften und Vorteile lassen sich analog übertragen auf das Metall-Keramik-Substrat als Einsatz und andersrum.

Ein weiterer Gegenstand der vorliegenden Erfindung ist ein Verfahren zur Herstellung eines als Einsatz vorgesehenen Metall-Keramik-Substrats für eine erfindungsgemäße Leiterplatte, umfassend
- Bereitstellen eines Metall-Keramik-Substrats mit einer Haupterstreckungsebene,
- Profilieren einer nicht parallel zur Haupterstreckungsebene verlaufenden Seitenfläche und/oder Realisieren eines gegenüber der Bauteilmetallisierung und/oder der Rückseitenmetallisierung in einer parallel zur Haupterstreckungsebene verlaufenden Richtung vorstehenden Keramikelements am Metall-Keramik-Substrat.

Alle für die Leiterplatte beschriebenen Eigenschaften und Vorteile lassen sich analog übertragen auf das Verfahren und andersrum.

Insbesondere ist es vorstellbar, dass ein Profilieren und/oder Freistellen, beispielsweise durch ein Ätzen, durch eine mechanische Bearbeitung, beispielsweise mittels eines Fräsens, durch die Bearbeitung mit Laserlicht und/oder durch einen Wasserstrahl erfolgt.

Vorzugsweise ist es vorgesehen, dass eine im Wesentlichen parallel zur Haupterstreckungsebene verlaufende Bauteilseite und/oder Rückseite mit einer Schutzschicht bzw. Resistschicht bedeckt wird und anschließend mittels eines Ätzmediums die Seitenfläche profiliert und/oder das Keramikelement teilweise freigelegt wird. Dadurch wird mittels eines einfachen Ätzprozesses eine gewünschte Profilierung der Seitenfläche und das Freistellen eines seitlich vorstehenden Abschnitts des Keramikelements auf einfache Weise realisiert.

Insbesondere ist es vorgesehen, dass der Einsatz aus einem als Großkarte bereitgestellten Metall-Keramik-Substrat herausgetrennt wird.

Ein weiterer Gegenstand der vorliegenden Erfindung ist ein Verfahren zur Herstellung einer Leiterplatte gemäß der vorliegenden Erfindung. Dabei ist es insbesondere vorgesehen, dass im Anschluss an das Bilden des Metall-Keramik-Substrats, das als Einsatz vorgesehen ist, das Metall-Keramik-Substrat in den Grundkörper der Leiterplatte eingesetzt wird.

Ferner ist es vorstellbar, dass die Seitenflächen der Einsätze vor dem Einsetzen in den Grundkörper geschliffen bzw. poliert werden.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsform können dabei im Rahmen der Erfindung miteinander kombiniert werden.

Es zeigt:
- **Fig.1:**: schematische Darstellung einer Leiterplatte gemäß einer ersten bevorzugten Ausführungsform der vorliegenden Erfindung in einer Draufsicht (oben) und einer Schnittansicht (unten)
- **Fig. 2a -2g:**: Verfahren zur Herstellung einer Leiterplatte gemäß einer ersten bevorzugten Ausführungsform der vorliegenden Erfindung
- **Fig. 3a und b**: Verfahren zur Herstellung von Metall-Keramik-Substraten für die Leiterplatten gemäß einer zweiten bevorzugten Ausführungsform der vorliegenden Erfindung
- **Fig. 4 und b**: Metall-Keramik-Substrate für Leiterplatten gemäß einer dritten bevorzugten Ausführungsform der vorliegenden Erfindung
- **Fig. 5.**: Metall-Keramik-Substrate für Leiterplatten gemäß einer dritten bevorzugten Ausführungsform der vorliegenden Erfindung und

Fig. 6 Metall-Keramik Substrat gemäß einer vierten bevorzugten Ausführungsform der vorliegenden Erfindung

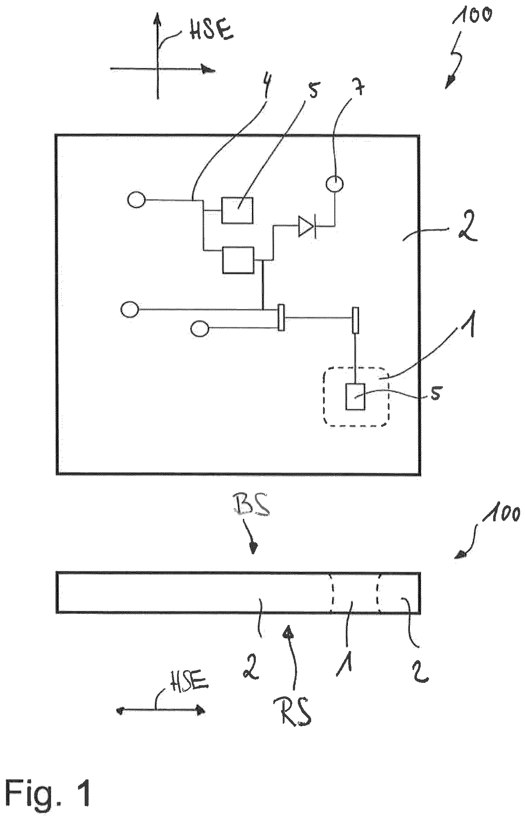

In **Figur 1** ist eine Leiterplatte 100 gemäß einer ersten bevorzugten Ausführungsform der vorliegenden Erfindung in einer Draufsicht (oben) und in eine Schnittansicht (unten) dargestellt. Solche Leiterplatten 100 dienen insbesondere als Träger für Schaltkreise, die aus elektrischen oder elektronischen Bauteilen 5, Anschlüssen 7 und/oder Leiterbahnen 4 gebildet werden. Die elektrischen oder elektronischen Bauteile 5, die Leiterbahnen 4 und/oder die Anschlüsse 7, beispielsweise in Form von Lötflächen (Pats) oder Lötaugen, sind dabei vorzugsweise an einer Bauteilseite BS der Leiterplatte 100 angeordnet bzw. angebunden. Für eine besonders kostengünstige Produktion derartiger Leiterplatten 100 hat es sich etabliert, Kunststoffe, insbesondere faserverstärkte Kunststoffe, Epoxidharz und/oder Hartpapier als Materialien für einen Grundkörper 2 zu verwenden, der sich im Wesentlichen entlang einer Haupterstreckungsebene HSE erstreckt und an dessen Bauteilseite BS die Anschlüsse 7, elektronischen Bauteile 5 und/oder Leiterbahnen 4 ausgebildet bzw. angebunden sind.

Aufgrund der stetigen Weiterentwicklung im Bereich der Elektronik, insbesondere in Hinblick auf ein Leistungsvermögen der elektrischen Bauteilen 5, hat es sich herausgestellt, dass die genannten für den Grundkörper 2 verwendeten Materialien den neuen Herausforderungen, insbesondere in Hinblick auf die im Betrieb entstehende Wärme, dauerhaft nicht standhalten können. Dies ist insbesondere dadurch bedingt, dass die genannten Materialien für den Grundkörper 2 einer Leiterplatte 100 eine vergleichsweise geringe Wärmeleitfähigkeit besitzen, wodurch die im Betrieb entstehende Wärme der elektrischen Bauteile nicht in einem ausreichenden Maße abgeführt werden kann.

Leiterplatten 100, die als Metall-Keramik-Substrate ausgebildet sind, können hingegen aufgrund ihrer erhöhten Wärmeleitfähigkeit, insbesondere gegenüber Leiterplatten aus Grundkörpern 2 aus den oben genannten Materialien, d. h. Kunststoffe, insbesondere faserverstärkte Kunststoffe, Epoxidharz und/oder Hartpapier, die entstehende Wärme in einem ausreichendem Maße abführen, sind allerdings fertigungstechnisch aufwendiger zu produzieren und kostenintensiv.

Um die positiven Eigenschaften einer Leiterplatte 100 aus einem Kunststoff, einem Epoxidharz oder einem Hartpapier und die positiven Eigenschaften eines Metall-Keramik-Substrats, insbesondere dessen Wärmeleitfähigkeit, zu nutzen, ist es vorzugsweise vorgesehen, dass die Leiterplatte 100 gemäß der in Figur 1 dargestellten Ausführungsform einen Grundkörper 2 aufweist, der sich entlang der Haupterstreckungsebene HSE erstreckt und in den ein Einsatz 1 integriert ist, wobei der Einsatz 1 als Metall-Keramik-Substrat bereitgestellt ist. Vorzugsweise ist es vorgesehen, dass das Metall-Keramik-Substrat, das als Einsatz 1 verwendet wird, in der Leiterplatte 100 an solchen Stellen angeordnet wird, an denen mit einer erhöhten Wärmeentwicklung zu rechnen ist. Beispielsweise ist es hierzu vorgesehen, dass der Einsatz 1 in einer senkrecht zur Haupterstreckungsebene HSE verlaufenden Stapelrichtung S unterhalb eines elektrischen Bauteils 5 oder mehrere elektrische Bauteile 5 angeordnet ist, um dessen Wärmeentwicklung im Betrieb abführen zu können. Vorzugsweise ist es dabei vorgesehen, dass eine Ausdehnung A des Einsatzes 1 größer ist als eine parallel zur Haupterstreckungsebene HSE bemessene Ausdehnung des elektrischen Bauteils, um eine wirksame Wärmeabfuhr zu garantieren.

Vorzugsweise ist es dabei vorgesehen, dass mindestens ein Einsatz 1, vorzugsweise mehrere Einsätze 1 in den Grundkörper 2 der Leiterplatte 100 integriert sind. Eine Bauteilseite BS des Einsatzes 1 schließt dabei im Wesentlichen bündig mit einer Bauteilseite BS des Grundkörpers 2 ab und/oder eine Rückseite RS des Einsatzes 1 schließt bündig mit der Rückseite RS des Grundkörpers 2 ab. Weiterhin ist es bevorzugt vorgesehen, dass ein Anteil eines Volumens des Einsatzes 1 oder mehrerer Einsätze 1 am Volumen des Grundkörpers 2 bzw. der ganzen Leiterplatte 100 kleiner als 20%, bevorzugt kleiner als 10% und besonders bevorzugt kleiner als 5% ist. Es hat sich herausgestellt, dass es mit derart niedrigen Anteilen bereits möglich ist, wirkungsvoll die thermischen Eigenschaften der Leiterplatte 100 zu verbessern und gleichzeitig überwiegend mit solchen Materialien für den Grundkörper 2 zu arbeiten, die einfach zu verarbeiten sind und weniger kostenintensiv sind als Metall-Keramik-Substrate.

Vorzugsweise ist es dabei vorgesehen, dass der Einsatz 1, der insbesondere an der Bauteilseite BS und der Rückseite RS bündig mit der Bauteilseite BS und Rückseite RS des Grundkörpers 2 in einer senkrecht zur Haupterstreckungsrichtung HSE verlaufenden Stapelrichtung S bündig abschließt, formschlüssig mit dem Grundkörper 2 in einer senkrecht zur Haupterstreckungsrichtung HSE verlaufenden Richtung zusammenwirkt. Dadurch wird ein sicherer Halt des Einsatzes 1 in der Leiterplatte 100 ermöglicht bzw. unterstützt. Vorzugsweise ist es vorgesehen, dass die Auswahl der Materialien, sei es ein Material des Grundkörpers 2 einerseits oder eines der Materialien oder mehrere Materialien des Keramikelements 30, derart erfolgt, dass die Differenzen der thermischen Ausdehnungskoeffizienten möglichst gering gehalten wird, um zu verhindern, dass thermomechanische Spannungen zu Rissen und/oder Schäden an der Leiterplatte 100 und/oder am Metall-Keramik-Substrat führen. Vorzugsweise weicht der thermische Ausdehnungskoeffizient des Einsatzes 1 vom thermischen Ausdehnungskoeffizienten des Grundkörpers 2 nicht mehr ab als 30 %, bevorzugt nicht mehr als 15 % und besonders bevorzugt nicht mehr als 10 % des thermischen Ausdehnungskoeffizienten des Einsatzes 1 ab. Zur Auswahl der in Frage kommenden Einsätze verwendet der Fachmann beispielsweise Simulationen für die jeweiligen Zusammensetzungen der Einsätze und vergleicht diese mit den Werten für den Grundkörper.

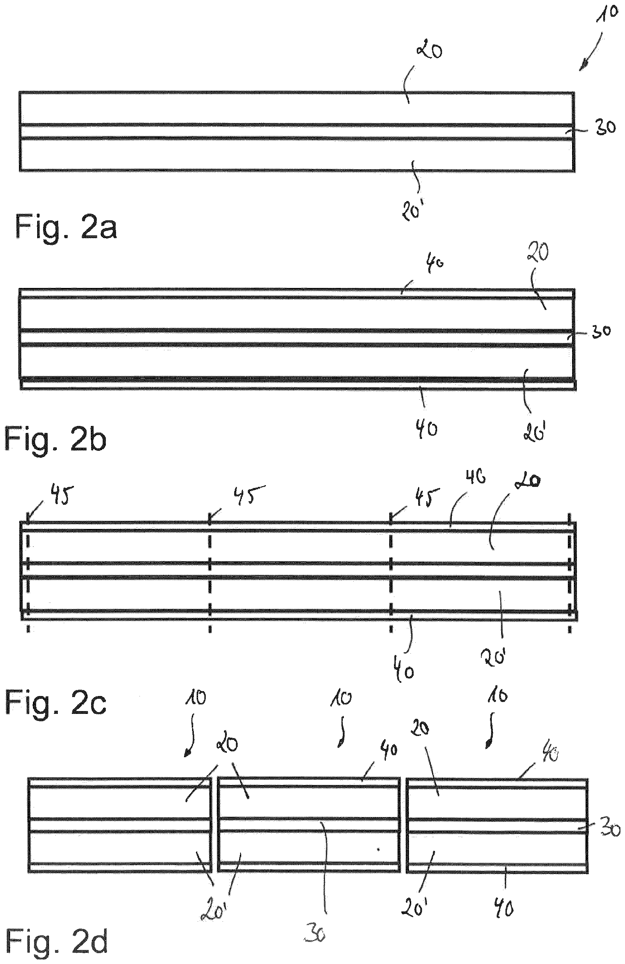

In den **Figuren 2a** - **2g** ist ein beispielhaftes Verfahren zur Herstellung eines als Einsatz 1 vorgesehenen Metall-Keramik-Substrats 10 illustriert. Hierzu ist es insbesondere vorgesehen, dass in einem ersten Schritt eine Anbindung einer Bauteilmetallisierung 20 an ein Keramikelement 30 erfolgt. In dem in Figur 2a dargestelltem ersten Schritt wird hierbei neben der Bauteilmetallisierung 20 ebenfalls eine Rückseitenmetallisierung 20' an das Keramikelement 30 angebunden. Die Anbindung der Bauteilmetallisierung 20 und/oder der Rückseitenmetallisierung 20' erfolgt vorzugsweise durch ein Direktmetallanbindungsverfahren, wie beispielsweise ein DCB- oder DAB-Verfahren, durch ein Lötverfahren, insbesondere ein Aktivlötmetallverfahren, durch einen Diffusionsanbindungsprozess und/oder ein hei-ßisostatisches Pressen. Vorstellbar ist auch die Anbindung über eine Dickfilmtechnik.

Das in Figur 2a bereitgestellte Metall-Keramik-Substrat wird in einem zweiten Schritt vorzugsweise an der Bauteilseite BS und der Rückseite RS des Metall-Keramik-Substrats mit einer Resist- bzw. Schutzschicht 40 versehen (siehe Figur 2b). Insbesondere ist darauf zu achten, dass sich die Schutzschicht 40 nicht an den Seitenflächen SF des Metall-Keramik-Substrats erstreckt, die nicht parallel, d. h. schräg, insbesondere senkrecht, zur Haupterstreckungsebene HSE verlaufen. Mit anderen Worten: die Seitenflächen SF des Metall-Keramik-Substrats bleiben frei von einer Schutzschicht 40.

In einem dritten Schritt (siehe Figur 2c) wird das Metall-Keramik-Substrat in kleinere als Einsatz 1 dienende Metall-Keramik-Substrate unterteilt, insbesondere derart dimensioniert, dass sie geeignet sind, als Einsatz 1 in einer Leiterplatte 100 verwendet werden zu können. Beispielsweise erfolgt hierbei die Trennung der vereinzelnden Metall-Keramik-Substrate über ein Wasserstrahlschneiden, unter Verwendung von Laserlicht, insbesondere Ultrakurzpulslaserlicht, durch ein mechanisches Verfahren, beispielsweise ein Fräsen und/oder durch einen Ätzschritt.

Die in Figur 2d dargestellten und für ihre Verwendung als Einsatz 1 dimensionierten Metall-Keramik-Substrate 10 sind insbesondere derart ausgestaltet, dass ihre Seitenflächen SF, d. h. deren Flächen, die nicht parallel zur Haupterstreckungsebene HSE verlaufen, frei sind von der Schutzschicht 40.

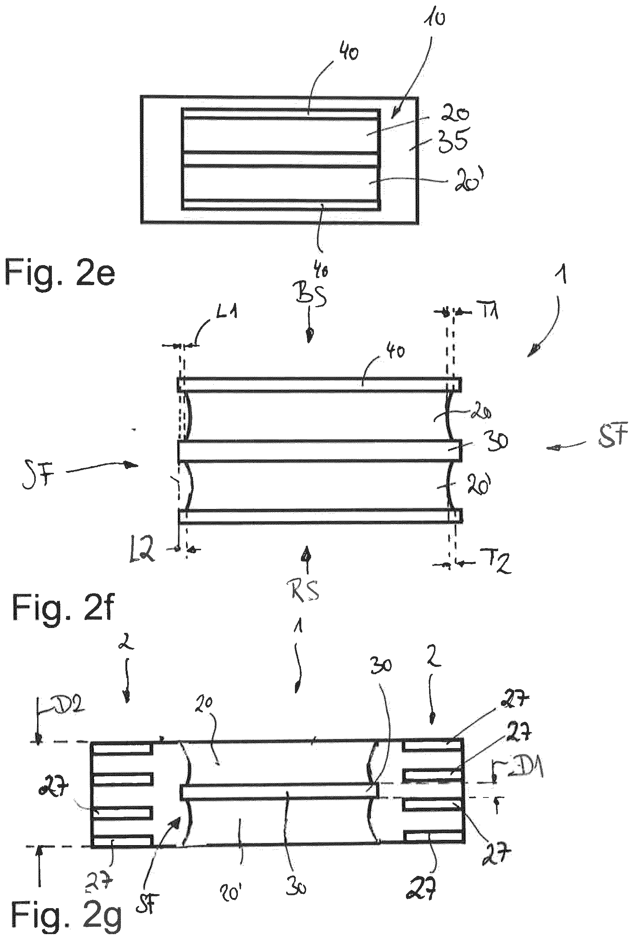

In dem in Figur 2e dargestellten Verfahrensschritt ist es vorgesehen, dass das vereinzelte Metall-Keramik-Substrat 10 in ein Ätzbad 35 gelegt wird. Wegen der Schutzschicht 40 bzw. Resistschicht wirkt das Ätzmittel des Ätzbades 35 ausschließlich an den Seitenflächen SF, an denen keine Schutzschicht 40 vorgesehen ist. Infolgedessen werden die Seitenflächen SF, insbesondere im Bereich der Bauteilmetallisierung 20 und/oder der Rückseitenmetallisierung 20`, profiliert und/oder das Keramikelement 30 freigestellt, insbesondere derart freigestellt, dass das Keramikelement 30 an der Seitenfläche SF in einer parallel zur Haupterstreckungsebene HSE verlaufenden Richtung gegenüber der Bauteilmetallisierung 20 und/oder Rückseitenmetallisierung 20' vorsteht. Dies ist in Figur 2f dargestellt.

Insbesondere zeigt der Einsatz 1 aus Figur 2f, dass das Keramikelement 30 gegenüber der Bauteilmetallisierung 20 in einer parallel zur Haupterstreckungsebene HSE verlaufenden Richtung um eine erste Länge L1 vorsteht und/oder das Keramikelement 30 steht gegenüber der Rückseitenmetallisierung 20' in einer parallel zur Haupterstreckungsebene HSE verlaufenden Richtung um eine zweite Länge L2 vor. Dabei ist es vorstellbar, dass die erste Länge L1 der zweiten Länge L2 entspricht und/oder die zweite Länge L2 ist kleiner oder größer als die erste Länge L1. Weiterhin ist es vorgesehen, dass durch das Ätzen ein profilierter Bereich in der Seitenfläche SF, insbesondere im Bereich der Bauteilmetallisierung 20 und/oder der Rückseitenmetallisierung 20' realisiert wird. In dem in Figur 2f dargestellten Ausführungsbeispiel ist die Bauteilmetallisierung 20 und/oder die Rückseitenmetallisierung 20' an den Seitenflächen SF bzw. an den der Seitenfläche SF des Metall-Keramik-Substrats liegenden Seiten gewölbt, insbesondere konvex gewölbt.

In dem in Figur 2g dargestelltem Verfahrensschritt wird der Einsatz 1 in den Grundkörper 2 eingelassen. Durch die Ausbildung der profilierten Seitenfläche SF und/oder durch das Vorstehen des Keramikelements 10 gegenüber der Bauteilmetallisierung 20 und/oder Rückseitenmetallisierung 20' ist es in vorteilhafter Weise möglich, dass im integrierten Zustand ein Formschluss zwischen dem Einsatz 1 und dem Grundkörper 2 der Leiterplatte 100 ausgebildet wird, der insbesondere senkrecht zur Haupterstreckungsebene HSE wirkt. Weiterhin ist es vorgesehen, dass das Keramikelement 30 eine in Stapelrichtung S bemessene erste Dicke D1 aufweist, während der Grundkörper 2 der Leiterplatte 100 eine in Stapelrichtung S bemessene zweite Dicke D2 aufweist. Vorzugsweise ist es vorgesehen, dass die erste Dicke D1 kleiner ist als die zweite Dicke D2, insbesondere ist ein Verhältnis der ersten Dicke D1 zu der zweiten Dicke D2 so dimensioniert, dass sie einen Wert zwischen 0,05 und 0,4, vorzugsweise 0,1 und 0,3 und besonders bevorzugt zwischen 0,15 und 0,25 annimmt. Dadurch ist es in vorteilhafter Weise möglich, das isolierend wirkende Keramikelement 30 ins Innere der Leiterplatte 100 zu versetzen. Dadurch ist es beispielsweise auch möglich, Leiterelemente 27, die insbesondere innerhalb der Leiterplatte bzw. des Grundkörpers 2 verlaufen, so anzuordnen, dass sie in Stapelrichtung S in mehreren Ebenen angeordnet sind, und mehrere dieser Ebenen auf Höhe der Metallisierung 20 und/oder der Rückseitenmetallisierung 20' angeordnet sind.

In den Figuren 2a bis 2g ist ein Beispiel für einen Einsatz 1 dargestellt, bei dem das Keramikelement 30 zwischen einer Bauteilmetallisierung 20 und einer Rückseitenmetallisierung 20' angeordnet ist, die im Wesentlichen in Stapelrichtung S dieselbe Dicke aufweisen. Infolgedessen ist das isolierend wirkende Keramikelement 30 mittig in Stapelrichtung S gesehen im Grundkörper 2 der Leiterplatte 100 angeordnet. Durch eine entsprechende Änderung der Dicke der Bauteilmetallisierung 20 und/oder der Rückseitenmetallisierung 20' ist es in vorteilhafter Weise möglich, eine Positionshöhe des isolierend wirkenden Keramikelements 30 innerhalb der Leiterplatte 100 zu steuern bzw. festzulegen. Beispielsweise ist die Bauteilmetallisierung 20 dicker als die Rückseitenmetallisierung 20`, um so die thermische Leitfähigkeit der Bauteilmetallisierung 20 zum Abführen der Wärme vom Bauteil zu nutzen. Dadurch wird insbesondere eine Wärmespreizung beim Transport der Wärme von der Bauteilseite BS zum Keramikelement 30 hin begünstigt, wodurch eine wirkungsvollere Wärmeabfuhr möglich wird. Beispielsweise ist es vorgesehen, dass das Keramikelement 30 in einem letzten Drittel, vorzugsweise letztem Viertel, besonders bevorzugt letzten Fünftel des Grundkörpers 2 - gemessenen in einer parallel zur Stapelrichtung S verlaufenden Richtung - angeordnet ist, die der Rückseite RS der Leiterplatte 100 und/oder des Einsatzes 1 zugewandt ist.

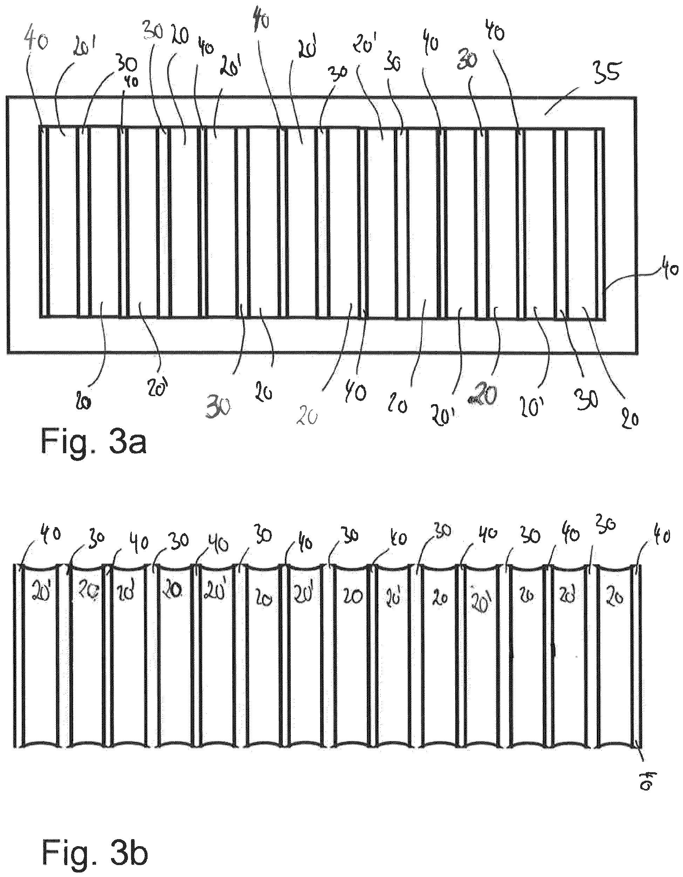

In den **Figuren 3a und 3b** ist ein Verfahren zur Herstellung von Metall-Keramik-Substraten für die Leiterplatte 100 gemäß einer zweiten bevorzugten Ausführungsform der vorliegenden Erfindung dargestellt. Dabei unterscheidet sich die Herstellung aus den Figuren 3a und 3b lediglich dahingehend von der Ausführungsform aus den Figuren 2a bis 2g, dass gleichzeitig mehrere vereinzelte Metall-Keramik-Substrate in einem Ätzbad 35 bearbeitet werden, um die Seitenflächen SF derart bereitzustellen, dass sie geeignet sind, einen Formschluss mit der Leiterplatte 100 bzw. im Grundkörper 2 der Leiterplatte 100 auszubilden, wenn sie in den Grundkörper 2 eingelassen werden. Dabei ist es insbesondere vorgesehen, dass die gemeinsam ins Ätzbad 35 eigebrachten vereinzelten Metall-Keramik-Substrate übereinander gestapelt sind, wobei die einzelnen Metall-Keramik-Substrate durch die Schutzschicht 40 voneinander getrennt sind bzw. durch eine gemeinsame Schutzschicht voneinander getrennt sind. In Figur 3b ist der Stapel aus den vielen vereinzelten Metall-Keramik-Substraten nach der Bearbeitung im Ätzbad 35 dargestellt und es ist das freigestellte Keramikelement 30 und/oder die profilierte Seitenfläche SF der vereinzelten Metall-Keramik-Substrate zu erkennen, die als Einsatz 1 einsetzbar wären.

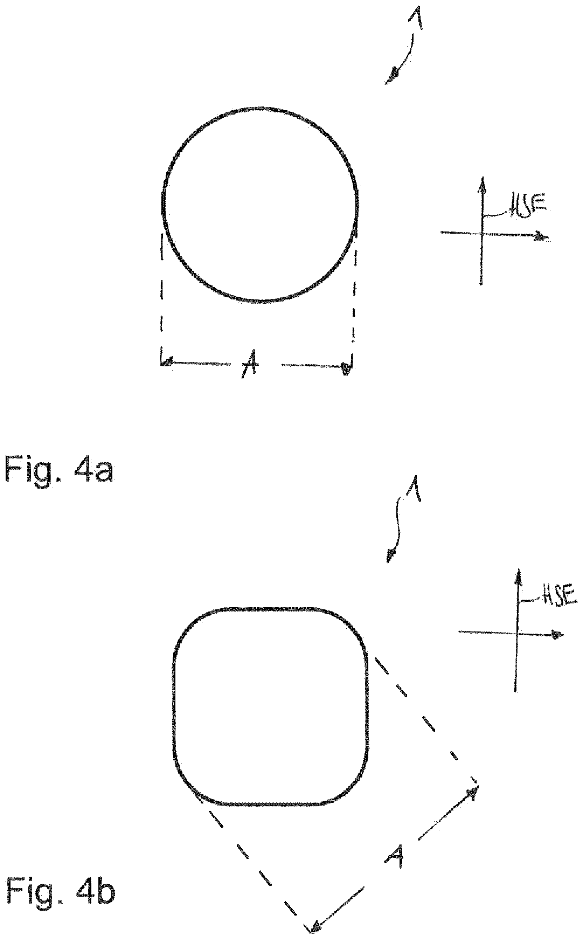

In den **Figuren 4a und 4b** sind Draufsichten auf Einsätze 1 dargestellt, die für Leiterplatten 100 gemäß der vorliegenden Erfindung bevorzugt vorgesehen sind. In den beiden Beispielen weist der Einsatz 1 einen kreisrunden Querschnitt in einer parallel zur Haupterstreckungsebene HSE verlaufenden Ebene auf (siehe Figur 4a) und/oder der Querschnitt des Einsatzes weist in einer parallel zur Haupterstreckungsebene HSE verlaufenden Ebene abgerundete Ecken auf (siehe Figur 4b). Die abgerundete Gestaltung des Einsatzes 1 ist insbesondere von Vorteil, weil dadurch eine Kerbwirkung reduziert wird, die andernfalls auf den Grundkörper 2 der Leiterplatte 100 wirken würde und so eventuell Risse erzeugen könnte. Vorzugsweise ist es vorgesehen, dass eine maximale Ausdehnung des Einsatzes 1 in einer parallel zur Haupterstreckungsebene HSE verlaufenden Ebene einen Wert unterhalb von 60 mm, vorzugsweise unterhalb von 50 mm und besonders bevorzugt unter 30 mm annimmt. Grundsätzlich sind auch ovale und rechteckige Querschnitte vorstellbar.

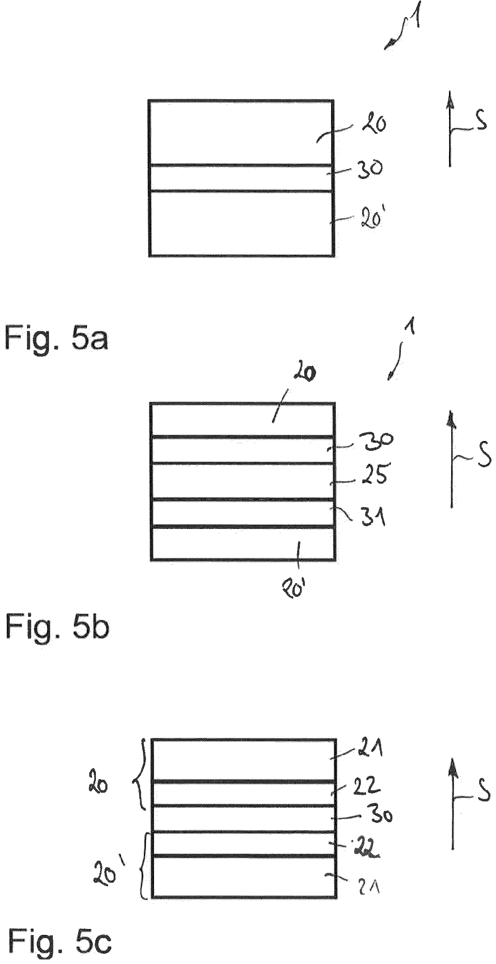

In den **Figuren 5a bis 5c** sind weitere Beispiele für als Einsatz 1 in einer Leiterplatte 100 vorgesehenen Metall-Keramik-Substrate in Schnittansichten dargestellt.

In dem in Figur 5a dargestellten Beispiel umfasst das Metall-Keramik-Substrat, das als Einsatz 1 gedacht, ist eine Bauteilmetallisierung 20, ein Keramikelement 30 und ein in Stapelrichtung S gesehen der Bauteilmetallisierung 20 gegenüberliegende Rückseitenmetallisierung 20`, wobei die Bauteilmetallisierung 20 und/oder die Rückseitenmetallisierung 20' an gegenüberliegenden Seiten des Keramikelements 30 angebunden sind.

In der Figur 5b ist es vorgesehen, dass zusätzlich zu dem Keramikelement 30 eine Stabilisierungsschicht 31 vorgesehen ist, wobei zwischen der Stabilisierungsschicht 31 und dem Keramikelement 30 eine metallische Zwischenschicht 25 angeordnet ist. Vorzugsweise handelt es sich bei der Stabilisierungsschicht 31 um ein weiteres Keramikelement. Es ist allerdings auch vorstellbar, dass die Stabilisierungsschicht aus Molybdän gebildet ist, um insbesondere so den thermischen Ausdehnungskoeffizienten des Metall-Keramik-Substrats zu beeinflussen, insbesondere anzugleichen an denjenigen der Leiterplatte 100.

Die in Figur 5c dargestellte Ausführungsform des Einsatzes 1 sieht eine Bauteilmetallisierung 20 und/oder eine Rückseitenmetallisierung 20' vor, die eine erste Metallschicht 21 und eine zweite Metallschicht 22 aufweist. Durch die Verwendung einer ersten Metallschicht 21 und zweiten Metallschicht 22 ist es in vorteilhafter Weise möglich, die Eigenschaften der Bauteilmetallisierung 20 zu optimieren. Beispielsweise ist es vorstellbar, dass im gefertigten Zustand die erste Metallschicht 21 eine feinere Körnung aufweist als die zweite Metallschicht 22. Dadurch wird zum einen eine Anbindung der Bauteilmetallisierung 20 über die gröbere Kornstruktur in der zweiten Metallschicht 22 begünstigt, während an der außen liegenden ersten Metallschicht 21 die feinere Körnung beispielsweise ein vereinfachtes Bonding oder Anbinden an Lotdrähte ermöglicht und/oder eine automatisch optische Inspektion der gefertigten Bauteile vereinfacht.

In Figur 6 ist eine vierte beispielhafte Ausführungsform der vorliegenden Erfindung dargestellt. Dabei unterscheidet sich diese Ausführungsform insbesondere gegenüber derjenigen aus Figur 2g dahingehend, dass die Bauteilmetallisierung 20 gegenüber der Rückseitenmetallisierung 20' vorsteht, um einen Seitenflächenverlauf des Einsatzes 1 zu realisieren, der einen Formschluss zwischen Einsatz 1 und Grundkörper 2 verursacht. Durch die in einer parallel zur Haupterstreckungsebene HSE vorlaufenden Richtung vorstehende Bauteilmetallisierung 20 wird eine Modulationstiefe M festgelegt. Außerdem ist zu erkennen, dass die Seitenfläche SF des Einsatzes 1 im Bereich des Keramikelements 30 einen gegenüber der Stapelrichtung S schrägen Verlauf hat. Dadurch wird der vorstehende Verlauf der Seitenfläche SF im Bereich der Bauteilmetallisierung 20 verursacht. Alternativ ist es auch vorstellbar, dass die Rückseitenmetallisierung 20' gegenüber dem Keramikelement 30 vorsteht. In dem in Figur 6 dargestellten Beispiel sind die Verläufe der Seitenfläche SF im Bereich der Bauteilmetallisierung 20 und der Rückseitenmetallisierung 20' parallel zur Stapelrichtung S. Vorstellbar ist auch, dass der Verlauf der Seitenfläche SF im Bereich der Rückseitenmetallisierung 20 und/oder Bauteilmetallisierung 20' zur Ausbildung der Modulationstiefe bzw. - höhe beiträgt. Grundsätzlich ist es auch denkbar, dass die Seitenflächen SF mehrere lokale Maxima und/oder Minima in ihrer Modulationstiefe/höhe aufweisen.

### Bezugszeichen:

- 1: Einsatz
- 2: Grundkörper
- 4: Leiterbahn
- 5: Bauteil
- 7: Anschluss
- 20: Bauteilmetallisierung
- 20': Rückseitenmetallisierung
- 21: erste Metallschicht
- 22: zweite Metallschicht
- 25: Zwischenschicht
- 27: Leiterelement
- 30: Keramikelement
- 31: Stabilisierungsschicht
- 35: Ätzbad
- 40: Schutzschicht
- 100: Leiterplatte
- A: Ausdehnung
- HSE: Haupterstreckungsebene
- S: Stapelrichtung
- D1: erste Dicke
- D2: zweite Dicke
- L1: erste Länge
- L2: zweite Länge
- T1: erste Tiefe
- T2: zweite Tiefe
- SF: Seitenfläche
- RS: Rückseite
- BS: Bauteilseite

## Patentansprüche

1. Leiterplatte (100) für elektrische Bauteile ( 5) und/oder Leiterbahnen (4), umfassend
- einen Grundkörper (2), der sich entlang einer Haupterstreckungsebene (HSE) erstreckt, und
- einen Einsatz (1), der in den Grundkörper (2) integriert ist,
wobei der Einsatz (1) ein Metall-Keramik-Substrat (10) ist und formschlüssig und stoffschlüssig mit dem Grundkörper (2) in einer senkrecht zur Haupterstreckungsebene (HSE) verlaufenden Richtung zusammenwirkt, wobei zum Ausbilden des formschlüssigen Zusammenwirkens das Metall-Keramik-Substrat an einer nicht parallel zur Haupterstreckungsebene (HSE) verlaufenden Seitenfläche (SF) profiliert ist, **dadurch gekennzeichnet, dass** die Seitenfläche (SF) derart profiliert ist, dass sich eine Modulationstiefe oder -höhe (M) einstellt, die einen Wert zwischen 20 µm und 100 µm annimmt.

2. Leiterplatte (100) gemäß Anspruch 1, wobei das Metall-Keramik-Substrat (10) in einer parallel zur Haupterstreckungsebene (HSE) bemessenen Ebene eine maximale Ausdehnung aufweist, die einen Wert zwischen 6 mm und 30 mm annimmt

3. Leiterplatte gemäß einem der vorhergehenden Ansprüche, wobei zum Ausbilden des formschlüssigen Zusammenwirkens ein Keramikelement (30) des Metall-Keramik-Substrats (10) in einer parallel zu Haupterstreckungsebene (HSE) verlaufenden Richtung gegenüber einer Bauteilmetallisierung (20) des Metall-Keramik-Substrats (10) um eine erste Länge (L1) vorsteht.

4. Leiterplatte (100) gemäß einem der vorhergehenden Ansprüche, wobei die Seitenfläche (SF) derart profiliert ist, dass sich eine Modulationstiefe oder-höhe (M) einstellt, die einen Wert zwischen 25 µm und 60 µm annimmt.

5. Leiterplatte (100) gemäß einem der vorhergehenden Ansprüche, wobei das Metall-Keramik-Substrat (10) in einer parallel zur Haupterstreckungsebene (HSE) verlaufenden Ebene eine maximale Ausdehnung (A) aufweist, die einen Wert zwischen 1 mm und 200 mm, bevorzugt zwischen 4 und 60 mm und besonders bevorzugt zwischen 6 und 30 mm annimmt.

6. Leiterplatte (100) gemäß einem der vorhergehenden Ansprüche, wobei das Metall-Keramik-Substrat (1) in der Haupterstreckungsebene (HSE) ein rundes Profil oder eine abgerundete Ecke aufweist.

7. Leiterplatte (100) gemäß einem der vorhergehenden Ansprüche, wobei das Metall-Keramik-Substrat (10) ein Keramikelement (30) aufweist, wobei an dem Keramikelement (30) eine Bauteilmetallisierung (20) angebunden ist, wobei eine der Bauteilmetallisierung (20) in einer senkrecht zur Haupterstreckungsebene (HSE) verlaufenden Stapelrichtung (S) gegenüberliegende Rückseitenmetallisierung (20`) vorgesehen ist.

8. Leiterplatte (100) gemäß einem der vorhergehenden Ansprüche, wobei das Metall-Keramik-Substrat (10) ein Keramikelement (30) aufweist, wobei an dem Keramikelement (30) eine Bauteilmetallisierung (20) angebunden ist, wobei eine Stabilisierungsschicht (31)vorgesehen ist, wobei zwischen dem Keramikelement (30) und der Stabilisierungsschicht (31) eine metallische Zwischenschicht (25) angeordnet ist.

9. Leiterplatte (100) gemäß einem der vorhergehenden Ansprüche, wobei das Metall-Keramik-Substrat (10) ein Keramikelement (30) aufweist, wobei an dem Keramikelement (30) eine Bauteilmetallisierung (20) angebunden ist, wobei die Bauteilmetallisierung (20) und/oder die Rückseitenmetallisierung (20') eine erste Metallschicht (21) und eine zweite Metallschicht (22) umfasst, wobei die erste Metallschicht (21) und die zweite Metallschicht (22) übereinander angeordnet sind.

10. Leiterplatte (100) gemäß einem der vorhergehenden Ansprüche, wobei der Grundkörper (2) der Leiterplatte (100) im Wesentlichen frei von Keramik ist.

11. Leiterplatte gemäß einem der vorhergehenden Ansprüche, wobei zusätzlich zu dem Formschluss ein Stoffschluss zwischen dem Grundkörper (2) und dem Einsatz (1) ausgebildet ist.

12. Verfahren zur Herstellung eines als Einsatz (1) vorgesehenen Metall-Keramik-Substrats (10) für eine Leiterplatte (100) gemäß einem der Ansprüche 1 bis 11, umfassend:
- Bereitstellen eines Metall-Keramik-Substrats (10) mit einer Haupterstreckungsebene (HSE),
- Profilieren einer nicht parallel zur Haupterstreckungsebene (HSE) verlaufenden Seitenfläche (S) und/oder Realisieren eines gegenüber der Bauteilmetallisierung (20) und/oder der Rückseitenmetallisierung (20`) in einer parallel zur Haupterstreckungsebene (HSE) verlaufenden Richtung vorstehenden Keramikelements (30) am Metall-Keramik-Substrat (1), wobei eine im Wesentlich parallel zur Haupterstreckungsebene (HSE) verlaufende Bauteilseite (BS) und/oder Rückseite (RS) mit einer Schutzschicht (40) bedeckt wird und anschließend mittels Ätzen die Seitenflächen (SF) profiliert und/oder das Keramikelement (30) freigelegt wird und wobei der Einsatz (1) in den Grundkörper (2) eingesetzt wird.

## Claims

1. A printed circuit board (100) for electrical components (5) and/or conductor paths (4), comprising
- a base body (2) which extends along a main extension plane (HSE), and
- an insert (1) which is integrated into the base body (2),
wherein the insert (1) is a metal-ceramic substrate (10) and interacts positively and materially with the base body (2) in a direction perpendicular to the main extension plane (HSE), wherein the metal-ceramic substrate is profiled on a side surface (SF) which does not run parallel to the main extension plane (HSE) in order to form the positive interaction, **characterized in that** the side surface (SF) is profiled in such a way that a modulation depth or height (M) is set which has a value of between 20 µm and 100 µm.

2. The printed circuit board (100) according to claim 1, wherein the metal-ceramic substrate (10) has a maximum extension in a plane dimensioned parallel to the main extension plane (HSE), which has a value between 6 mm and 30 mm

3. The printed circuit board according to one of the preceding claims, wherein a ceramic element (30) of the metal-ceramic substrate (10) projects by a first length (L1) in a direction running parallel to the main extension plane (HSE) relative to a component metallization (20) of the metal-ceramic substrate (10) in order to form the material interaction.

4. The printed circuit board (100) according to one of the preceding claims, wherein the side surface (SF) is profiled in such a way that a modulation depth or height (M) is set which has a value between 25 µm and 60 µm.

5. The printed circuit board (100) according to one of the preceding claims, wherein the metal-ceramic substrate (10) has a maximum extension (A) in a plane running parallel to the main extension plane (HSE), which has a value between 1 mm and 200 mm, more preferably between 4 and 60 mm and most preferably between 6 and 30 mm.

6. The printed circuit board (100) according to one of the preceding claims, wherein the metal-ceramic substrate (1) has a round profile or a rounded corner in the main extension plane (HSE).

7. The printed circuit board (100) according to one of the preceding claims, wherein the metal-ceramic substrate (10) comprises a ceramic element (30), wherein a component metallization (20) is bonded to the ceramic element (30), wherein a backside metallization (20') opposite the component metallization (20) in a stacking direction (S) running perpendicular to the main extension plane (HSE) is provided.

8. The printed circuit board (100) according to one of the preceding claims, wherein the metal-ceramic substrate (10) comprises a ceramic element (30), wherein a component metallization (20) is bonded to the ceramic element (30), wherein a stabilizing layer (31) is provided, wherein a metallic intermediate layer (25) is arranged between the ceramic element (30) and the stabilizing layer (31).

9. The printed circuit board (100) according to one of the preceding claims, wherein the metal-ceramic substrate (10) comprises a ceramic element (30), wherein a component metallization (20) is bonded to the ceramic element (30), wherein the component metallization (20) and/or the backside metallization (20') comprises a first metal layer (21) and a second metal layer (22), wherein the first metal layer (21) and the second metal layer (22) are arranged on top of each other.

10. The printed circuit board (100) according to one of the preceding claims, wherein the base body (2) of the printed circuit board (100) is substantially free of ceramic.

11. The printed circuit board according to one of the preceding claims, wherein, in addition to the positive fit, a material connection is formed between the base body (2) and the insert (1).

12. A method of manufacturing a metal-ceramic substrate (10) provided as an insert (1) for a printed circuit board (100) according to any one of claims 1 to 11, comprising:
- Providing a metal-ceramic substrate (10) having a main extension plane (HSE),
- profiling a side surface (S) not parallel to the main extension plane (HSE) and/or realizing a ceramic element (30) on the metal-ceramic substrate (1) protruding with respect to the component metallization (20) and/or the backside metallization (20') in a direction parallel to the main extension plane (HSE), wherein a component side (BS) and/or back side (RS) extending substantially parallel to the main extension plane (HSE) is covered with a protective layer (40) and subsequently the side surfaces (SF) are profiled by etching and/or the ceramic element (30) is exposed and wherein the insert (1) is inserted into the base body (2).

## Revendications

1. Carte de circuit imprimé (100) pour composants électriques (5) et/ou pistes conductrices (4), comprenant
- un corps de base (2) qui s'étend le long d'un plan d'extension principale (HSE), et
- un insert (1) qui est intégré au corps de base (2),
dans laquelle
l'insert (1) est un substrat métal-céramique (10) et coopère avec le corps de base (2) par complémentarité de forme et par complémentarité de matière dans une direction s'étendant perpendiculairement au plan d'extension principale (HSE), pour établir la coopération par complémentarité de forme, le substrat métal-céramique est profilé sur une surface latérale (SF) qui n'est pas parallèle au plan d'extension principale (HSE),
**caractérisée en ce que**
la surface latérale (SF) est profilée de manière à établir une profondeur ou hauteur de modulation (M) qui prend une valeur comprise entre 20 µm et 100 µm.

2. Carte de circuit imprimé (100) selon la revendication 1,
dans laquelle le substrat métal-céramique (10) présente, dans un plan parallèle au plan d'extension principale (HSE), une extension maximale (A) qui prend une valeur comprise entre 6 mm et 30 mm.

3. Carte de circuit imprimé selon l'une des revendications précédentes,
dans laquelle, pour établir la coopération par complémentarité de forme, un élément céramique (30) du substrat métal-céramique (10) fait saillie d'une première longueur (L1) par rapport à une métallisation de composant (20) du substrat métal-céramique (10), dans une direction parallèle au plan d'extension principale (HSE).

4. Carte de circuit imprimé (100) selon l'une des revendications précédentes,
dans laquelle la surface latérale (SF) est profilée de manière à établir une profondeur ou hauteur de modulation (M) qui prend une valeur comprise entre 25 µm et 60 µm.

5. Carte de circuit imprimé (100) selon l'une des revendications précédentes,
dans laquelle le substrat métal-céramique (10) présente, dans un plan parallèle au plan d'extension principale (HSE), une extension maximale (A) qui prend une valeur comprise entre 1 mm et 200 mm, de préférence entre 4 et 60 mm et de manière particulièrement préférée entre 6 et 30 mm.

6. Carte de circuit imprimé (100) selon l'une des revendications précédentes,
dans laquelle le substrat métal-céramique (1) présente un profil arrondi ou un coin arrondi dans le plan d'extension principale (HSE).

7. Carte de circuit imprimé (100) selon l'une des revendications précédentes,
dans laquelle le substrat métal-céramique (10) comprend un élément céramique (30), une métallisation de composant (20) étant liée à l'élément céramique (30), et
il est prévu une métallisation de face arrière (20') opposée à la métallisation de composant (20) dans une direction d'empilement (S) perpendiculaire au plan d'extension principale (HSE).

8. Carte de circuit imprimé (100) selon l'une des revendications précédentes,
dans laquelle le substrat métal-céramique (10) comprend un élément céramique (30), une métallisation de composant (20) étant liée à l'élément céramique (30), il est prévu une couche de stabilisation (31), et
une couche intermédiaire métallique (25) est disposée entre l'élément céramique (30) et la couche de stabilisation (31).

9. Carte de circuit imprimé (100) selon l'une des revendications précédentes,
dans laquelle le substrat métal-céramique (10) comprend un élément céramique (30), une métallisation de composant (20) étant liée à l'élément céramique (30), la métallisation de composant (20) et/ou la métallisation de face arrière (20') présentent) une première couche métallique (21) et une deuxième couche métallique (22), la première couche métallique (21) et la deuxième couche métallique (22) étant superposées.

10. Carte de circuit imprimé (100) selon l'une des revendications précédentes,
dans laquelle le corps de base (2) de la carte de circuit imprimé (100) est sensiblement exempt de céramique.

11. Carte de circuit imprimé selon l'une des revendications précédentes,
dans laquelle, en supplément à la liaison par complémentarité de forme, une liaison par complémentarité de matière est réalisée entre le corps de base (2) et l'insert (1).

12. Procédé de fabrication d'un substrat métal-céramique (10) prévu comme insert (1) pour une carte de circuit imprimé (100) selon l'une des revendications 1 à 11, consistant à :
- fournir un substrat métal-céramique (10) présentant un plan d'extension principale (HSE),
- profiler une surface latérale (S) non parallèle au plan d'extension principale (HSE), et/ou réaliser sur le substrat métal-céramique (1) un élément céramique (30) faisant saillie par rapport à la métallisation de composant (20) et/ou à la métallisation de face arrière (20') dans une direction parallèle au plan d'extension principale (HSE),
dans lequel une face de composant (BS) et/ou une face arrière (RS) s'étendant sensiblement parallèlement au plan d'extension principale (HSE) est recouverte d'une couche de protection (40), puis les surfaces latérales (SF) sont profilées par attaque chimique et/ou l'élément céramique (30) est mis à découvert, et l'insert (1) est inséré dans le corps de base (2).
